Europäisches Patentamt

European Patent Office

Office européen des brevets

(19)

(11) Veröffentlichungsnummer : **0 028 797**
**B1**

(12)                    **EUROPÄISCHE PATENTSCHRIFT**

(45) Veröffentlichungstag der Patentschrift :
16.02.83

(21) Anmeldenummer : 80106775.2

(22) Anmeldetag : 04.11.80

(51) Int. Cl.³ : **H 01 L 29/74**, H 01 L 29/52,
**H 01 L 29/08**

(54) **Thyristor mit verbessertem Schaltverhalten und Verfahren zu seinem Betrieb.**

(30) Priorität : 09.11.79 DE 2945324

(43) Veröffentlichungstag der Anmeldung :
20.05.81 Patentblatt 81/20

(45) Bekanntmachung des Hinweises auf die Patenterteilung : 16.02.83 Patentblatt 83/07

(84) Benannte Vertragsstaaten :
CH FR GB IT LI SE

(56) Entgegenhaltungen :
DE A 2 625 917
FR A 1 362 724

(73) Patentinhaber : **SIEMENS AKTIENGESELLSCHAFT**
**Berlin und München Wittelsbacherplatz 2**
**D-8000 München 2 (DE)**

(72) Erfinder : **Patalong, Hubert, Dr.**
**Kurt-Floericke-Strasse 18**
**D-8000 München 60 (DE)**

## Thyristor mit verbessertem Schaltverhalten und Verfahren zu seinem Betrieb

Die Erfindung bezieht sich auf einen Thyristor nach dem Oberbegriff des Anspruchs 1 oder 2 und auf Verfahren zu seinem Betrieb.

Thyristoren dieser Art sind aus der US-A-3 243 669 bekannt. Beim Anlegen einer Steuerspannung an das Gate einer MIS-Struktur wird hierbei ein Kurzschlußpfad wirksam geschaltet, der den PN-Übergang zwischen der mit der Kathode (Anode) verbundenen Emitterschicht und der angrenzenden Basisschicht überbrückt. Das hat eine Umschaltung des Thyristors aus dem stromführenden Zustand in den blockierten Zustand zur Folge, in dem zwischen Kathode und Anode trotz einer in Durchlaßrichtung anliegenden Spannung praktisch kein Strom fließt. Die Umschaltung aus dem blockierten Zustand in den stromführenden Zustand erfolgt durch das Anlegen einer weiteren Steuerspannung an das Gate einer weiteren MIS-Struktur, die den PN-Übergang zwischen den beiden Basisschichten niederohmig überbrückt. Gleichzeitig wird für die Dauer des stromführenden Zustands die den Kurzschlußpfad wirksam schaltende Steuerspannung abgeschaltet.

Der in den Ansprüchen gekennzeichneten. Erfindung liegt die Aufgabe zugrunde, einen Thyristor der eingangs genannten Art anzugeben, der durch einfache Steuervorgänge kontrolliert gezündet und wieder blockiert werden kann. Diese Aufgabe wird durch die im Anspruch 1 gekennzeichneten Merkmale gelöst.

Der mit der Erfindung gemäß Anspruch 1 oder 2 erzielbare Vorteil liegt insbesondere darin, daß der sich im stromführenden Zustand befindende Thyristor nach Zuführung eines ersten Steuerimpulses an das Gate wenigstens einer MIS-Struktur des ersten Typs solange blockiert wird, bis er beim Auftreten eines zweiten Steuerimpulses, der dem Gate wenigstens einer MIS-Struktur des anderen Typs zugeführt wird, wieder zündet. Zur Aufrechterhaltung des blockierten oder des stromführenden Zustands ist es nicht notwendig, den MIS-Strukturen eine Steuerspannung zuzuführen, wie das bei den bekannten Thyristoren mit den MIS-Kurzschlußpfaden der Fall ist. Die MIS-Strukturen des einen Typs, die nur während des Zündvorgangs vorübergehend unwirksam geschaltet werden, bestimmen dabei die Stabilität des erfindungsgemäßen Thyristors, d. h. seine Sicherheit gegen unbeabsichtigte Zündvorgänge beim Auftreten von in Durchlaßrichtung gepolten Spannungen an der Anoden-Kathoden-Strecke. Schließlich entfällt auch eine Steuerung des PN-Übergangs zwischen den beiden Basisschichten, die bei den bekannten Thyristoren der eingangs genannten Art vorgenommen wird.

Die Ansprüche 3 bis 11 sind auf bevorzugte Weiterbildungen und Ausgestaltungen der Erfindung gerichtet, während die Ansprüche 12 und 13 bevorzugte Verfahren zum Betrieb eines erfindungsgemäßen Thyristors betreffen.

Die Erfindung wird nachfolgend anhand der Zeichnung näher erläutert. Dabei zeigt :

Figur 1 den Querschnitt eines ersten Ausführungsbeispiels der Erfindung,

Figur 2 eine Draufsicht der Anordnung nach Figur 1,

Figur 3 den Querschnitt eines zweiten Ausführungsbeispiels und

Figur 4 den Querschnitt eines dritten Ausführungsbeispiels.

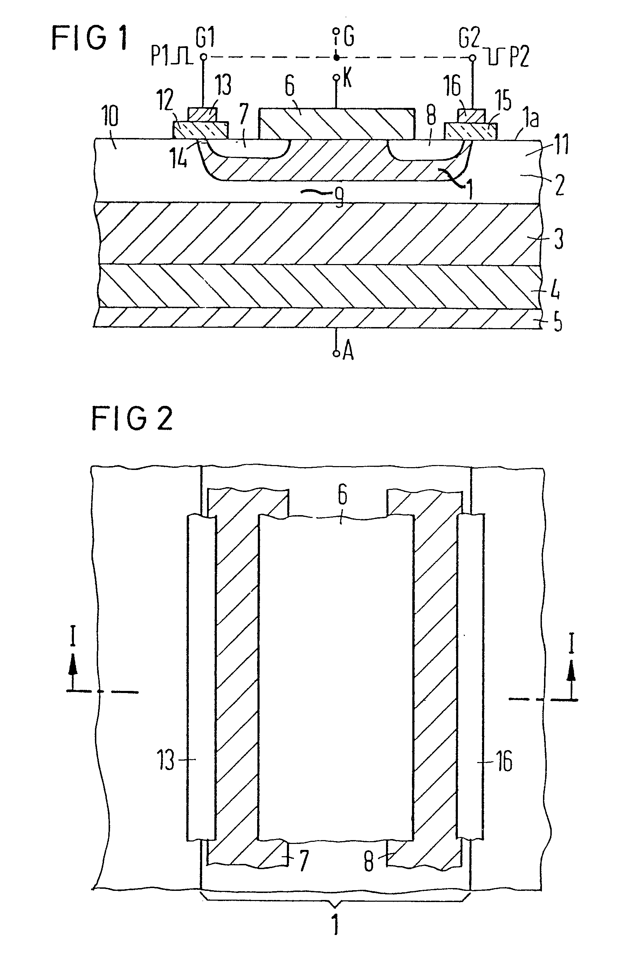

Der Halbleiterkörper des in Figur 1 und Figur 2 dargestellten Thyristors weist Halbleiterschichten 1 bis 4 abwechselnder Leitfähigkeitstypen auf, die beispielsweise aus dotiertem Silizium bestehen. Dabei werden die außen liegende N-leitende Schicht 1 als N-Emitterschicht und die außen liegende P-leitende Schicht 4 als P-Emitterschicht bezeichnet. Die P-leitende Schicht 2 und die N-leitende Schicht 3 stellen die sogenannten Basisschichten dar. Die P-Emitterschicht 4 ist mit einer Anode 5 versehen, die einen Anodenanschluß A besitzt, während die N-Emitterschicht 1 von der Kathode 6 kontaktiert wird, die mit einem Kathodenanschluß K versehen ist. Die N-Emitterschicht 1 ist zweckmäßigerweise streifenförmig ausgebildet und in der Draufsicht der Figur 2 als vertikal verlaufender Streifen erkennbar.

In der Figur 1, die einen Querschnitt längs der Linie I-I von Figur 2 zeigt, sind P-leitende erste Halbleitergebiete 7 und 8 dargestellt, die in die N-Emitterschicht 1 so eingefügt sind, daß sie sich bis zur Grenzfläche 1a des Halbleiterkörpers erstrecken. In Figur 2 sind die Oberflächen dieser Halbleitergebiete der besseren Übersicht wegen schraffiert dargestellt. Die Gebiete 7 und 8 werden jeweils randseitig von der Kathode 6 kontaktiert. Mit 9, 10 und 11 sind einzelne Zonen der Basisschicht 2 bezeichnet, die bis an die Grenzfläche 1a reichen. Dabei werden die Gebiete 7 und 8 durch die Zone 9 voneinander getrennt.

Das Gebiet 7 bildet ein erstes P-Gebiet, die Zone 10 ein zweites P-Gebiet und der dazwischenliegende Teil der Emitterschicht 1 eine N-Zwischenschicht. Auf der Grenzfläche 1a ist eine dünne, elektrisch isolierende Schicht 12, z. B. aus $SiO_2$, vorgesehen, auf der ein Gate 13 so angeordnet ist, daß es die N-Zwischenschicht überdeckt. Die Teile 7, 9, 10, 12 und 13 bilden eine MIS-Struktur. Gehört sie dem Verarmungstyp an, so befindet sich ohne Einwirkung einer Spannung auf das Gate 13 ein P-leitender Inversionskanal 14 an der Grenzfläche 1a zwischen den Gebieten 7 und 10, der diese leitend miteinander verbindet. Legt man eine positive Steuerspannung an einen Steuerspannungsanschluß G1 des Gates 13, so wird der Inversionskanal 14 beseitigt. Ist die MIS-Struktur vom Verarmungstyp, so besteht bei spannungslosem Gate 13 kein Inversionskanal 14. Dieser wird erst durch das Anliegen einer negativen Steuerspannung an G1 durch Inversion der Emitterschicht 1 aufgebaut. Der Inversionskanal 14 stellt somit einen steuerbaren Emitter-Kurzschluß dar, der die Basisschicht 2 mit dem Gebiet 7 und damit mit der Kathode 6 in Abhängigkeit von einer dem Anschluß G1 zugeführten Steuerspannung niederohmig verbindet oder nicht.

Durch die Anordnung einer elektrisch isolierenden Schicht 15, z. B. aus SiO$_2$, auf der ein mit einem Anschluß G2 verbundenes Gate 16 vorgesehen ist, ergibt sich eine entsprechende MIS-Struktur 8, 9, 11, 15 und 16 am rechten Rand der N-Emitterschicht 1, die einen über den Anschluß G2 steuerbaren Emitter-Kurzschluß darstellt.

Es ist nun ein wesentliches Merkmal der Erfindung, daß die eine der beiden MIS-Strukturen, z. B. die Struktur 7, 9, 10, 12 und 13, dem Verarmungstyp angehört und die andere MIS-Struktur, im betrachteten Fall also die Struktur 8, 9, 11, 12 und 16, dem Anreicherungstyp. Eine hierzu äquivalente Maßnahme ist allerdings darin zu sehen, daß beide Strukturen vom Verarmungstyp sind und einer von ihnen, z. B. der Struktur 8, 9, 11, 15 und 16, über den ihr zugeordneten Anschluß, z. B. G2, eine positive Vorspannung zugeführt wird. Die Vorspannung verhindert dabei zunächst eine Kanalbildung. Erst durch eine weitere, diesem Anschluß zugeführte Steuerspannung, die eine zu der Vorspannung entgegengesetzte Polarität aufweist, wird dann ein Kurzschlußkanal wirksam. Andererseits können auch beide MIS-Strukturen vom Anreicherungstyp sein, wobei dann einer von ihnen eine negative Vorspannung zugeführt wird, die die Bildung eines Inversionskanals bewirkt. Wesentlich ist bei allen diesen Varianten, daß, gegebenenfalls unter Einbeziehung einer dem Anschluß G1 oder G2 zugeführten Vorspannung, die eine der beiden MIS-Strukturen ohne Zuführung einer weiteren Steuerspannung einen Inversionskanal, z. B. 14, und damit einen wirksam geschalteten Emitter-Kurzschluß aufweist, die andere dagegen nicht.

Für die folgenden Überlegungen sei angenommen, daß unterhalb des Gate 13 der Inversionskanal 14 vorhanden ist, während unterhalb des Gate 16 kein Inversionskanal besteht. Der Kanal 14 bewirkt hierbei, daß die thermisch erzeugten Defektelektronen aus der Basisschicht 2 zur Kathode 6 abgeleitet werden, so daß aus der N-Emitterschicht 1 keine Ladungsträger in die Basisschicht 2 injiziert werden. Das bedeutet, daß sich der Thyristor im blockierten Zustand befindet, in dem trotz einer an A und B anliegenden, in Durchlaßrichtung gepolten Spannung praktisch kein Strom zwischen A und B fließt.

Führt man dem Anschluß G1 einen positiven Spannungsimpuls P1 zu, so wird der allein bestehende Emitterkurzschluß für die Dauer von P1 unwirksam geschaltet, wobei die Zündung des Thyristors erfolgt. Danach fließt ein Laststrom eines an A und K angeschlossenen Lastkreises über den niederohmig geschalteten Thyristor. Zum Blockieren des Thyristors wird nun ein negativer Spannungsimpuls P2 dem Anschluß G2 zugeführt, ohne daß die an A und K liegende, in Durchlaßrichtung gepolte Spannung abgeschaltet zu werden braucht. Während des Anliegens von P2 sind beide Emitter-Kurzschlüsse wirksam, so daß die die Basisgebiete 2 und 3 überschwemmenden Defektelektronen über diese Kurzschlüsse zur Kathode K abgeleitet werden. Hierdurch wird das Injizieren von Ladungsträgern aus der N-Emitterschicht 1 in die Basisschicht 2 unterbunden, so daß der Thyristor wieder in den blockierten Zustand gelangt.

Bei den oben beschriebenen Ausbildungen der MIS-Strukturen, die die Anwendung einer Vorspannung erforderlich machen, ergibt sich die gleiche Wirkungsweise, wenn jeweils dafür Sorge getragen wird, daß die den Anschlüssen G1 und G2 zugeführten Impulse P1 bzw. P2 eine zu der betreffenden Vorspannung entgegengesetzte Polarität aufweisen.

Anstelle der N-Emitterschicht 1 kann auch die P-Emitterschicht 4 durch zwei MIS-Strukturen unterschiedlichen Typs, die steuerbare Kurzschlüsse zwischen der Basisschicht 3 und der Anode 5 bilden, wahlweise niederohmig überbrückt werden. Die Figur 1 kann zur Erläuterung dieser Ausgestaltung herangezogen werden, wenn man die Elektrode 5 als Kathode und die Elektride 6 als Anode auffaßt, die Leitfähigkeitstypen sämtlicher Halbleiterteile durch die entgegengesetzten ersetzt, die Polaritäten der Spannungen bzw. Spannungsimpulse umkehrt und die Bezeichnungen A und K miteinander vertauscht. Das beschriebene Betriebsverhalten des Thyristors ändert sich hierdurch nicht.

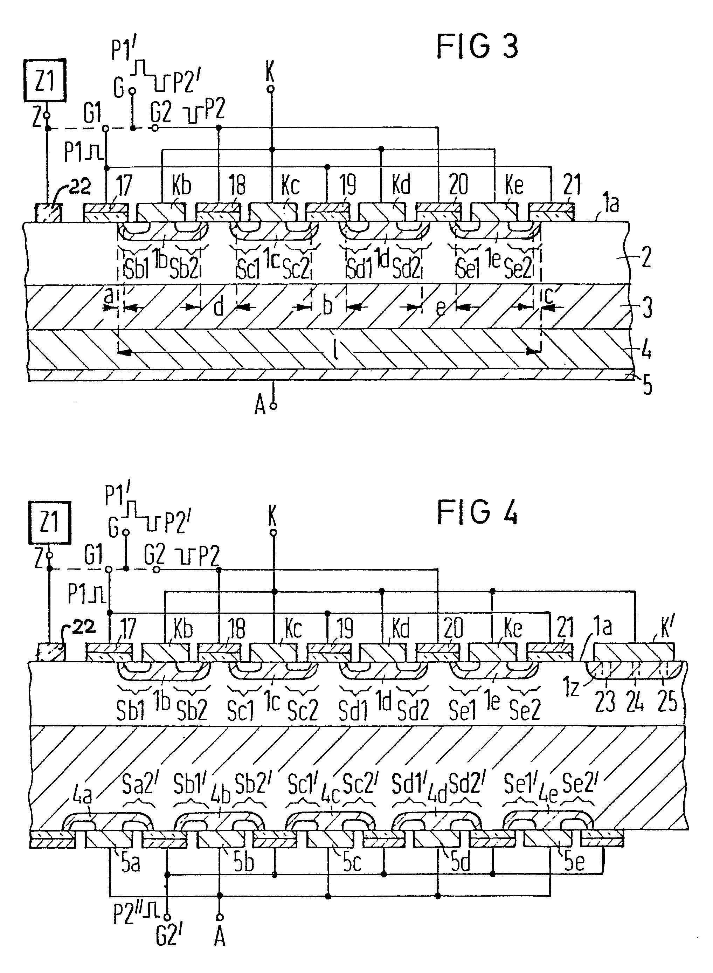

Der in Figur 3 dargestellte Thyristor unterscheidet sich von Figur 1 dadurch, daß die N-Emitterschicht in eine Mehrzahl von Emitterzonen 1b bis 1e aufgeteilt ist, die jeweils mit untereinander leitend verbundenen Teilen Kb bis Ke der Kathode versehen sind, die an einem gemeinsamen Kathodenanschluß K liegen. Randseitig zu den Emitterzonen 1b bis 1e sind jeweils zwei MIS-Strukturen Sb1, Sb2, Sc1, Sc2, Sd1, Sd2 und Se1, Se2 der bereits beschriebenen Art vorgesehen. Das Gate der Struktur Sb1 ist mit 17 bezeichnet, während die Gates der Strukturen Sb2 und Sc1 zu einem gemeinsamen Gate 18, die Gates von Sc2 und Sd1 zu einem gemeinsamen Gate 19 und die Gates von Sd2 und Se1 zu einem gemeinsamen Gate 20 verbunden sind. Die MIS-Struktur Se2 weist ein Gate 21 auf.

Die Wirkungsweise des Thyristors nach Figur 3 entspricht der des Thyristors nach Figur 1, wobei in den mit G1 verbundenen MIS-Strukturen Sb1, Sc2, Sd1 und Se2 beim Fehlen eines Impulses P1 Kurzschlußkanäle vorhanden sind, während in den mit G2 verbundenen MIS-Strukturen Sb2, Sc1, Sd2 und Se1 ohne einen Impuls P2 keine Kurzschlußkanäle vorhanden sind. Durch Anlegen von P1 gelangt der Thyristor durch eine kurzzeitige Aufhebung der bestehenden Kurzschlüsse aus dem blockierten Zustand in den stromführenden Zustand, in dem er solange verbleibt, bis er durch einen angelegten Impuls P2, der auch in den letztgenannten MIS-Strukturen Kurzschlüsse entstehen läßt, die sich zu den Kurzschlüssen in den erstgenannten MIS-Strukturen in ihrer Wirkung addieren, wieder blockiert wird.

Zur Erzielung einer guten Stabilität des Thyristors nach Figur 3, d. h. zur Erzielung einer großen Unempfindlichkeit gegenüber im blockierten Zustand zwischen Anode und Kathode anliegenden, in Durchlaßrichtung gepolten Spannungen, die ja keine unerwünschten Zündvorgänge hervorrufen sollen, ist es zweckmäßig, daß diejenigen MIS-Strukturen, die ohne anliegende Impulse P1 und P2 Kurzschlußkanäle aufweisen, etwa zwischen 0,01 % und 3 % der von den N-Emitterzonen 1b bis 1e belegten lateralen Thyristorfläche bedecken. In Figur 3 sind Strecken a, b und c eingezeichnet, die in ihrer Summe ein Maß für die von diesen MIS-Strukturen belegten lateralen Thyristorfläche darstellen. Die Strecke I stellt ein Maß für die gesamte von den Emitterzonen 1b bis 1e belegte laterale Thyristorfläche dar. Nach obigem ergibt sich eine gute Stabilität bei Erfüllung der Bedingung

$$3 : 100 > (a + b + c) : 1 > 1 : 10\,000.$$

Für die Länge eines einzelnen Kurzschlußkanals kommen dabei Werte von etwa 2 bis 3 μm in Betracht, insbesondere bei einer Kurzschlußbelegung der von den Emitterzonen belegten lateralen Thyristorfläche zwischen 2 und 3 %.

Andererseits ist es zum sicheren Umschalten des Thyristors aus dem stromführenden Zustand in den blockierten Zustand zweckmäßig, daß die während des Auftretens von P2 wirksamen Emitterkurzschlüsse etwa zwischen 3 % und 10 % der gesamten von den Emitterzonen 1b bis 1e belegten lateralen Thyristorfläche einnehmen. Das ist der Fall, wenn für die in Figur 3 eingezeichneten Strecken a bis e und I die Beziehung gilt

$$1 : 10 > (a + b + c + d + e) : 1 > 3 : 100.$$

Dabei entsprechen die Strecken d und e der Fläche derjenigen MIS-Strukturen, die lediglich beim Auftreten von P2 mit Kurzschlußpfaden versehen sind. Die Prinzipdarstellung der Figur 3 läßt die tatsächlichen Größenverhältnisse aus Gründen der Übersichtlichkeit unberücksichtigt.

Auch der zuletzt beschriebene Thyristor kann so abgeändert werden, daß die steuerbaren Emitterkurzschlüsse die P-Emitterschicht 4 wahlweise niederohmig überbrücken. Zur Darstellung dieser Lösungsvariante dient die Figur 3, wenn man 1b bis 1e als P-Emitterzonen, die Teile Kb bis Ke als Teile der Anode und die Elektrode 5 als Kathode auffaßt, die Leitfähigkeitstypen sämtlicher Halbleiterteile durch die jeweils entgegengesetzten ersetzt und die Spannungen bzw. Spannungsimpulse jeweils umpolt.

Figur 3 zeigt eine Weiterbildung der Erfindung, die darin besteht, daß eine herkömmliche Zündelektrode 22 auf einem in der Grenzfläche 1 a liegenden Teil der Basisschicht 2 angeordnet ist. Diese ist über einen Anschluß Z mit einem herkömmlichen Zündstromkreis Z1 verbunden.

Durch den über 22 fließenden Zündstrom wird ein sehr schneller Ablauf des Zündvorgangs erreicht. Die Zündelektrode 22 kann auch mit dem Anschluß G1 verbunden sein, wobei dann der Impuls P1 aus der an 22 abgreifbaren Zündspannung besteht.

Nach einer anderen Weiterbildung der Erfindung werden die Anschlüsse G1 und G2 mit einem gemeinsamen Anschluß G verbunden, dem eine Impulsspannung mit den Impulsen P1′ und P2′ zugeführt wird. Die beschriebene Betriebsweise des Thyristors ändert sich hierdurch nicht.

Figur 4 zeigt ein der Figur 3 teilweise entsprechendes, weiteres Ausführungsbeispiel. Im Unterschied zu Figur 3 ist auch die P-Emitterschicht in Emitterzonen 4a bis 4e aufgeteilt, die jeweils mit untereinander verbundenen Teilen 5a bis 5e der Anode versehen sind. Diese sind mit dem gemeinsamen Anodenanschluß A verbunden. Randseitig zu den Emitterzonen 4a bis 4e sind MIS-Strukturen Sa2′, Sb1′, Sb2′, Sc1′, Sc2′, Sd1′, Sd2′, Se1′ und Se2′ vorgesehen, die über einen Anschluß G2′ und einen Impuls P2″ angesteuert werden, der mit P2 zeitlich zusammenfällt, aber eine zu diesem entgegengesetzte Polarität aufweist. Diese MIS-Strukturen weisen Emitterkurzschlüsse auf, die jeweils nur während des Umschaltens aus dem stromführenden Zustand in den blockierten Zustand wirksam geschaltet sind. Werden im Sinne der anhand von Figur 3 dargelegten Belegungsregeln etwa 3 % bis 10 % der von den P-Emitterzonen insgesamt belegten lateralen Thyristorfläche mit diesen Emitterkurzschlüssen belegt, so wird ein sehr schneller und sicherer Umschaltvorgang erzielt.

In Figur 4 können die auf der Grenzfläche 1a angeordneten MIS-Strukturen, deren Emitterkurzschlüsse nur während des Umschaltens aus dem stromführenden in den blockierten Zustand wirksam geschaltet sind, auch entfallen.

Figur 4 zeigt noch eine weitere Ausgestaltung der Erfindung. Danach ist neben den bereits anhand von Figur 3 beschriebenen N-Emitterzonen noch eine weitere N-Emitterzone 1z vorgesehen, die von einem weiteren Teil K′ der Kathode kontaktiert wird. Sie wird von Zonen 23 bis 25 der Basisschicht 2 durchdrungen, die sich bis zur Grenzfläche 1a erstrecken und in dieser ebenfalls von K′ kontaktiert werden. Die Zonen 23 bis 25 bilden feste N-Emitterkurzschlüsse, die beim Thyristor nach Figur 4, der wegen der Emitterzone 1z größere Lastströme beherrscht als der Thyristor nach Figur 3, ein Absinken der Stabilität verhindern.

Die Emitterzonen 1b bis 1z können, wie in Figur 2 angedeutet ist, über die ganze Thyristorfläche geradlinig verlaufen, wobei eine gegebenenfalls vorhandene Zündelektrode 22 zweckmäßigerweise ebenfalls streifenförmig ausgebildet ist. Das gleiche gilt für die Emitterzonen 4a bis 4e in Figur 4. Andererseits können die Emitterzonen auch als konzentrische Ringe ausgebildet sein, wobei eine Zündelektrode 22 mit Vorteil im Zentrum derselben angeordnet ist.

Weitere Emitterzonen 1z werden dann ebenfalls ringförmig angeordnet.

## Ansprüche

1. Thyristor mit einem Halbleiterkörper, der eine außen liegende, mit einer Kathode (6) versehene N-Emitterschicht (1), eine außen liegende, mit einer Anode (5) versehene P-Emitterschicht (4) und zwei an diese jeweils angrenzende Basisschichten (2, 3) enthält, und mit an wenigstens einer Grenzfläche des Halbleiterkörpers angeordneten, als MIS-Strukturen ausgebildeten, steuerbaren Emitterkurzschlüssen, (7, 9, 10, 12, 13 ; 8, 9, 10, 15, 16) die jeweils ein mit der Kathode (K) bzw. Anode (A) verbundenes erstes Halbleitergebiet (7, 8) eines ersten Leitfähigkeitstyps, ein mit der an die jeweilige Emitterschicht angrenzenden Basisschicht verbundenes zweites Halbleitergebiet (10, 11) des ersten Leitfähigkeitstyps und eine zwischen diesen Gebieten liegende Zwischenschicht eines zweiten Leitfähigkeitstyps, die von einem gegenüber dem Halbleiterkörper elektrisch isolierten Gate (13, 16) überdeckt ist, aufweisen, dadurch gekennzeichnet, daß wenigstens eine MIS-Struktur des Verarmungstyps (7, 9, 10, 12, 13) und wenigstens eine MIS-Struktur des Anreicherungstyps (8, 9, 11, 15, 16) vorhanden sind und daß ein gemeinsamer Steuerspannungsanschluß (G1) für die Gates der MIS-Strukturen des Verarmungstyps und ein gemeinsamer Steuerspannungsanschluß (G2) für die Gates der MIS-Strukturen des Anreicherungstyps vorgesehen sind.

2. Thyristor mit einem Halbleiterkörper, der eine außen liegende, mit einer Kathode (6) versehene N-Emitterschicht (1), eine außen liegende, mit einer Anode (5) versehene P-Emitterschicht (4) und zwei an diese jeweils angrenzende Basisschichten (2, 3) enthält, und mit an wenigstens einer Grenzfläche des Halbleiterkörpers angeordneten, als MIS-Strukturen ausgebildeten, steuerbaren Emitterkurzschlüssen (7, 9, 10, 12, 13 ; 8, 9, 10, 15, 16), die jeweils ein mit der Kathode (K) bzw. Anode (A) verbundenes erstes Halbleitergebiet (7, 8) eines ersten Leitfähigkeitstyps, ein mit der an die jeweilige Emitterschicht angrenzenden (10, 11) Basisschicht verbundenes zweites Halbleitergebiet des ersten Leitfähigkeitstyps und eine zwischen diesen Gebieten Liegende Zwischenschicht eines zweiten Leitfähigkeitstyps, die von einem gegenüber dem Halbleiterkörper elektrisch isolierten Gate überdeckt ist, aufweisen, dadurch gekennzeichnet, daß wenigstens zwei MIS-Strukturen des Verarmungstyps (7, 9, 10, 12, 13 ; 8, 9, 11, 15, 16) oder des Anreicherungstyps vorhanden sind, daß das Gate (16) einer der zwei MIS-Strukturen mit einer Vorspannung beschaltet ist, die im Falle des Verarmungstyps eine ohne Vorspannung in der Zwischenschicht (9) vorhandene Inversionsschicht beseitigt oder im Falle des Anreicherungstyps eine Inversionsschicht in der Zwischenschicht (9) bildet, und daß für das mit einer Vorspannung beschaltete Gate (16) ein Steuerspannungsanschluß (G2) und für das (die) Gate(s) (13) der anderen MIS-Struktur(en) ein weiterer Steuerspannungsanschluß (G1) vorgesehen sind.

3. Thyristor nach Anspruch 1 oder 2, dadurch gekennzeichnet, daß die N-Emitterschicht und/oder die P-Emitterschicht in eine Mehrzahl von Emitterzonen (1b .... 1e) aufgeteilt ist, die jeweils mit untereinander leitend verbundenen Teilen der Kathode (Kb ... Ke) bzw. Anode versehen sind, und daß eine Mehrzahl von streifenförmigen MIS-Strukturen (SB1... Se2) vorgesehen sind, die an den Röndern der Emitterzonen (1b ... 1e) angeordnet sind.

4. Thyristor nach einem der Ansprüche 1 bis 3, dadurch gekennzeichnet, daß ein gemeinsamer Steuerspannungsanschluß (G) für die Gates der MIS-Strukturen beider Typen vorgesehen ist.

5. Thyristor nach einem der Ansprüche 1 bis 4, dadurch gekennzeichnet, daß die MIS-Strukturen des einen und die MIS-Strukturen des anderen Typs gemeinsam auf der mit der Kathode (K) bzw. Anode (A) versehenen Grenzfläche (1a) des Halbleiterkörpers angeordnet sind.

6. Thyristor nach einem der Ansprüche 1 bis 4, dadurch gekennzeichnet, daß die MIS-Strukturen des einen Typs auf der mit der Anode versehenen Grenzfläche und die MIS-Strukturen des anderen Typs auf der mit der Kathode versehenen Grenzfläche (1a) des Halbleiterkörpers angeordnet sind.

7. Thyristor nach einem der Ansprüche 1 bis 4, dadurch gekennzeichnet, daß MIS-Strukturen beider Typen gemeinsam auf der mit der Kathode (K) bzw. Anode (A) versehenen Grenzfläche und MIS-Strukturen eines der beiden Typen auf der mit der Anode (A) bzw. Kathode (K) versehenen Grenzfläche des Halbleiterkörpers angeordnet sind.

8. Thyristor nach einem der vorhergehenden Ansprüche, dadurch gekennzeichnet, daß die ersten Halbleitergebiete (7, 8) der MIS-Strukturen jeweils derart in die Emitterschicht oder Emitterzonen eingefügt sind, daß sie sich bis zu der jeweils angrenzenden Grenzfläche des Halbleiterkörpers erstrecken, in der sie mit der Kathode (K) bzw. Anode (A) leitend verbunden sind, daß die zweiten Halbleitergebiete der MIS-Strukturen jeweils aus Zonen (10, 11) der an die Emitterschicht oder Emitterzonen angrenzenden Basisschicht bestehen und sich bis an die gleiche Grenzfläche wie die ersten Halbleitergebiete erstrecken und daß die Zwischenschichten jeweils aus den Teilen der Emitterschicht (9) bestehen, die sich zwischen den einander gegenüberliegenden Grenzflächen der Zonen (10, 11) der Basisschicht und der ersten Halbleitergebiete (7, 8) befinden.

9. Thyristor nach einem der Ansprüche 1 bis 8, dadurch gekennzeichnet, daß wenigstens eine weitere Emitterzone (1z) vorgesehen ist, die mit einem weiteren Teil der Kathode (K') bzw. Anode versehen ist, und daß wenigstens eine weitere Zone (23) der angrenzenden Basisschicht die weitere Emitterzone (1z) bis zu der ihr benachbarten Grenzfläche (1a) des Halbleiterkörpers durchdringt und in dieser Grenzfläche mit dem weiteren Teil der Kathode (K') bzw. Anode verbunden ist.

10. Thyristor nach einem der vorhergehenden Ansprüche, dadurch gekennzeichnet, daß eine Basisschicht (2) oder eine Zone derselben mit einer Zündelektrode (22) versehen ist, die einen Anschluß (Z) für einen Zündstromkreis (Z1) aufweist.

11. Thyristor nach Anspruch 10, dadurch gekennzeichnet, daß der Anschluß für den Zündstromkreis (Z) mit dem Steuerspannungsanschluß (G1) der MIS-Strukturen des Verarmungstyps verbunden ist.

12. Verfahren zum Betrieb eines Thyristors nach Anspruch 1, dadurch gekennzeichnet, daß dem Steuerspannungsanschluß (G1) der MIS-Strukturen des Verarmungstyps ein die Umschaltung des Thyristors aus dem Blockierten Zustand in den stromführenden Zustand veranlassender Spannungsimpuls (P1) einer ersten Polarität zugeführt wird und daß dem Steuerspannungsanschluß (G2) der MIS-Strukturen des Anreicherungstyps ein die Umschaltung des Thyristors aus dem stromführenden Zustand in den blockierten Zustand veranlassender Spannungsimpuls (P2) einer zweiten Polarität zugeführt wird.

13. Verfahren zum Betrieb eines Thyristors nach Anspruch 4, dadurch gekennzeichnet, daß dem gemeinsamen Steuerspannungsanschluß (G) der MIS-Strukturen ein die Umschaltung des Thyristors aus dem blockierten Zustand in den stromführenden Zustand veranlassender Spannungsimpuls (P1') einer ersten Polarität und ein die Umschaltung aus dem stromführenden Zustand in den blockierten Zustand veranlassender Spannungsimpuls (P2') einer zweiten Polarität zugeführt werden.

## Claims

1. A thyristor comprising a semiconductor body which contains an N-emitter layer (1) arranged on the outside and provided with a cathode (6), a P-emitter layer (4) arranged on the outside and provided with an anode (5) and two base layers (2, 3) which respectively adjoin these emitter layers, and also comprising controllable emitter short circuits (7, 9, 10, 12, 13 ; 8, 9, 10, 15 16) which are in the form of MIS-structures arranged on at least one bounding surface of the semiconductor body and respectively have a first semiconductor zone (7, 8) of a first conductivity type which is connected to the cathode (K) or the anode (A), as the case may be, a second semiconductor zone (10, 11) of the first conductivity type which is connected to the base layer adjoining the particular emitter layer in question, and an intermediate layer of a second conductivity type which lies between these zones and is covered by a gate (13, 16) electrically insulated from the semiconductor body, characterised in that at least one MIS-structure of the depletion type (7, 9, 10, 12, 13) and at least one MIS-structure of the enhancement type (8, 9, 11, 15, 16) are provided ; and that a common control voltage terminal (G1) for the gates of the MIS-structures of the depletion type, and a common control voltage terminal (G2) for the gates of the MIS-structures of the enhancement type, are provided.

2. A thyristor comprising a semiconductor body which contains an N-emitter layer (1) arranged on the outside and provided with a cathode (6), a P-emitter layer (4) arranged on the outside and provided with an anode (5) and two base layers (2, 3) which respectively adjoin these emitter layers, and also comprising controllable emitter short circuits (7, 9, 10, 12, 13 ; 8, 9, 10, 15, 16) which are in the form of MIS-structures arranged on at least one bounding surface of the semiconductor body and which respectively have a first semiconductor zone (7, 8) of a first conductivity type which is connected to the cathode (K) or the anode (A), as the case may be, a second semiconductor zone (10, 11) of the first conductivity type which is connected to the base layer adjoining the particular emitter layer in question, and an intermediate layer of a second conductivity type which lies between these zones and is covered by a gate (13, 16) which is electrically insulated from the semiconductor body, characterised in that at least two MIS-structures of the depletion type (7, 9, 10, 12, 13 ; 8, 9, 11, 15, 16) or of the enhancement type, are provided ; and that the gate (16) of one of the two MIS-structures is provided with a bias voltage which, in the case of the depletion type, removes an inversion layer which is present in the intermediate layer (9) in the absence of a bias voltage, or, in the case of the enhancement type, forms an inversion layer in the intermediate layer (9); and that a control voltage terminal (G2) is provided for the gate (16) which is supplied with a bias voltage and a further control voltage terminal (G1) is provided for the gate(s) (13) of the other MIS-structure(s).

3. A thyristor according to Claim 1 or Claim 2, characterised in that the N-emitter layer and/or the P-emitter layer is or are divided into a plurality of emitter zones (1b ... 1e) which are respectively provided with conductively interconnected parts of the cathode (Kb ... Ke) and/or anode ; and that a plurality of strip-shaped MIS-structures (Sb1 ... Se2) arranged at the edges of the emitter zones (1b ... 1e), are provided.

4. A thyristor according to one of Claims 1 to 3, characterised in that a common control voltage terminal (G) is provided for the gates of the MIS-structures of both types.

5. A thyristor according to one of Claims 1 to 4, characterised in that the MIS-structures of the one and the MIS-structures of the other type are commonly arranged on the bounding surface (1a) of the semiconductor body which is provided with the cathode (K) or the anode (A), as the case may be.

6. A thyristor according to one of Claims 1 to 4, characterised in that the MIS-structures of the one type are arranged on the bounding surface of the semiconductor body which is provided with the anode, and the MIS-structures of the other type are arranged on the bounding surface (1a) of the semiconductor body which is provided with the cathode.

7. A thyristor according to one of Claims 1 to 4, characterised in that MIS-structures of both types are commonly arranged on the bounding surface of the semiconductor body provided with the cathode (K), or the anode (A), and MIS-structures of one of the two types are arranged on the bounding surface of the semiconductor body which is provided with the anode (A) or the cathode (K), as the case may be.

8. A thyristor according to one of the preceding Claims, characterised in that the first semiconductor zones (7, 8) of the MIS-structures are respectively inserted into the emitter layer or emitter zones in such manner that they extend to the respective adjoining bounding surface of the semiconductor body, at which boundary surface they are conductively connected to the cathode (K) or anode (A), as the case may be ; and that the second semiconductor zones of the MIS-structures respectively consist of zones (10, 11) of the base layer adjoining the emitter layer or emitter zones and extend to the same boundary surface as the first semiconductor zones ; and that the intermediate layers respectively consist of the portions of the emitter layer (9) which are arranged between the bounding surfaces, lying opposite to one another, of the zones (10, 11) of the base layer and of the first semiconductor zones (7, 8).

9. A thyristor according to one of Claims 1 to 8, characterised in that there is provided at least one further emitter zone (1z) which is provided with a further part of the cathode (K') or anode, as the case may be ; and that at least one further zone (23) of the adjoining base layer penetrates into the further emitter zone (1z) up to the adjacent bounding surface (1a) of the semiconductor body and is connected to the further part of the cathode (K') or anode at this boundary surface.

10. A thyristor according to one of the preceding Claims, characterised in that a base layer (2) or a zone thereof is provided with an ignition electrode (22) having a terminal (Z) for an ignition circuit (Z1).

11. A thyristor according to Claim 10, characterised in that the terminal for the ignition circuit (Z) is connected to the control voltage terminal (G1) of the MIS-structures of the depletion type.

12. A method of operating a thyristor according to Claim 1, characterised in that the control voltage terminal (G1) of the MIS-structures of the depletion type is fed with a voltage pulse (P1) of a first polarity which causes the thyristor to be switched over from the blocked state to the current-carrying state ; and that the control voltage terminal (G2) of the MIS-structures of the enhancement type is fed with a voltage pulse (P2) of a second polarity which causes the thyristor to be switched over from the current-carrying state to the blocked state.

13. A method of operating a thyristor according to Claim 4, characterised in that the common control voltage terminal (G) of the MIS-structures is fed with a voltage pulse (P1') of a first polarity which causes change-over of the thyristor from the blocked state to the current-carrying state, and with a voltage pulse (P2') of a second polarity which causes change-over from the current-carrying state into the blocked state.

**Revendications**

1. Thyristor à corps semiconducteur qui comporte une couche d'émetteur N (1) située à l'extérieur et pourvue d'une cathode (6), avec une couche d'émetteur P (4) située à l'extérieur et pourvue d'une anode (5), et deux couches de base (2, 3), voisines respectivement de celles-ci, et avec des courts-circuits (7, 9, 10, 12, 13 ; 8, 9, 10, 15, 16) d'émetteur disposés à au moins une surface limite du corps semiconducteur, susceptibles d'être commandés et réalisés comme des structures MIS, chacun de ces courts-circuits comportant une première plage semiconductrice (7, 8) d'un premier type de conductibilité et reliée à la cathode (K) ou à l'anode (A), une seconde plage semiconductrice (10, 11) du premier type de conductibilité et reliée à la couche de base qui avoisine la couche d'émetteur respective, et une couche intermédiaire d'un second type de conductibilité, située entre ces plages et qui est recouverte d'une grille (13, 16) isolée électriquement par rapport au corps semiconducteur, caractérisé par le fait qu'il est prévu au moins une structure MIS du type à appauvrissement (7, 9, 10, 12, 13) et au moins une structure MIS du type à enrichissement (8, 9, 11, 15, 16), et qu'il est prévu une borne d'application de la tension de commande (G1), comme pour les grilles des structures MIS du type à appauvrissement et une borne d'application de la tension de commande (G2) commune pour les structures MIS à type à enrichissement.

2. Thyristor à corps semiconducteur qui comporte une couche d'émetteur N (1) située à l'extérieur et pourvue d'une cathode (6), avec une couche d'émetteur P (4) située à l'extérieur et pourvue d'une anode (5), et deux couches de base (2, 3), voisines respectivement de celle-ci, et avec les courts-circuits (7, 9, 10, 12, 13 ; 8, 9, 10, 15, 16) d'émetteurs disposés à au moins une surface limite du corps semiconducteur, susceptible d'être commandés et réalisés comme des structures MIS, chacun de ces courts-circuits comportant une première plage semiconductrice (7, 8) d'un premier type de conductibilité et reliée à la cathode (K) ou à l'anode (1), une seconde plage semiconductrice (10, 11) du premier type de conductibilité et reliée à la couche de base qui avoisine la couche d'émetteur respective, et une couche intermédiaire d'un second type de conductibilité, située entre ces plages et qui est recouverte d'une grille (13, 16) isolée électriquement par rapport au corps semiconducteur, caractérisé par le fait qu'il est prévu au moins deux structures MIS du type à appauvrissement (7, 9, 10, 12, 13 ; 8, 9, 11, 15, 16) ou du type à enrichissement, que la grille (16) de l'une des deux structures MIS reçoit une tension de polarisation qui, dans le cas du type à appauvrissement supprime une couche d'inversion qui est présente dans la couche intérieure (9) quand il n'y a pas de tension de polarisation ou qui forme, dans le cas du type à enrichissement, une couche d'inversion dans la couche intermédiaire (9), et qu'il est prévu pour la grille (16) recevant une tension de polarisation, une borne (G2) d'application de la tension de commande et pour la (les) grille(s) (13) de l'autre ou des autres structures MIS, une autre borne (G1) d'application de la tension de commande.

3. Thyristor selon la revendication 1 ou 2, caractérisé par le fait que la couche d'émetteur N et/ou la couche d'émetteur P est subdivisée en plusieurs zones d'émetteurs (1b .... 1e) qui sont respectivement reliées avec des parties, reliées entre elles de façon conductrice, de la cathode (Kb .... Ke) ou de l'anode, et qu'il est prévu plusieurs structures MIS (Sb1 .... Se2), en forme de bandes qui sont disposées sur les bords des zones d'émetteurs (1b ... 1e).

4. Thyristor selon l'une des revendications 1 à 3, caractérisé par le fait qu'il est prévu une borne (G) commune pour l'application de la tension de commande pour les grilles des structures MIS des deux types.

5. Thyristor selon l'une des revendications 1 à 4, caractérisé par le fait que les structures MIS de l'un et les structures MIS de l'autre type sont disposées en commun sur la surface limite (1a) du corps semiconducteur, ou qui est pourvue de la cathode (K) ou de l'anode (A).

6. Thyristor selon l'une des revendications 1 à 4, caractérisé par le fait que les structures MIS du premier type sont disposées sur la surface limite qui est pourvue de l'anode et les structures MIS de l'autre type sont disposées sur la surface limite (1a) du corps semiconducteur, qui est pourvue de la cathode.

7. Thyristor selon l'une des revendications 1 à 4, caractérisé par le fait que les structures MIS des deux types sont disposées en commun sur la surface limite qui est pourvue de la cathode (K) ou de l'anode (A), et les structures MIS de l'un des deux types sont disposées sur la surface limite du corps semiconducteur, qui est pourvue de l'anode (A) ou de la cathode (K).

8. Thyristor selon l'une des revendications précédentes, caractérisé par le fait que les premières plages semiconductrices (7, 8) des structures MIS sont respectivement insérées de telle façon dans la couche d'émetteur ou dans les zones d'émetteur qu'elles s'étendent jusqu'à respectivement la surface limite respective du corps semiconducteur dans laquelle elles sont reliées de façon conductrice avec la cathode (K) ou l'anode (A), que les secondes plages semiconductrices MIS sont respectivement constituées par des zones (10, 11) de la couche de base qui avoisine la couche d'émetteur ou les zones d'émetteur, et s'étendent jusqu'à la même surface limite que les premières plages semiconductrices, et que des couches intermédiaires sont constituées respectivement par des parties de la couche d'émetteur (9) qui se situe entre les surfaces limites, situées l'une en face de l'autre, des zones (10, 11) de la couche de base et des premières plages semiconductrices (7, 8).

9. Thyristor selon l'une des revendications 1 à 8, caractérisé par le fait qu'il est prévu au moins une zone d'émetteur supplémentaire (1z) qui est pourvue d'une partie supplémentaire de la cathode (K') ou de l'anode A, et qu'au moins une zone supplémentaire (23) de la couche de base avoisinante traverse la zone d'émetteur supplémentaire jusqu'à la surface limite 1a qui lui est voisine, du corps semiconducteur, et est dans cette surface limite reliée avec la surface supplémentaire de la cathode (K') ou de l'anode.

10. Thyristor selon l'une des revendications précédentes, caractérisé par le fait qu'il est prévu une couche de base (2) ou une zone de celle-ci avec une électrode de déclenchement (22) qui comporte une borne de raccordement (Z) pour un circuit de courant de déclenchement (Z1).

11. Thyristor selon la revendication 10, caractérisé par le fait que la borne pour le circuit du courant de déclenchement (Z) est reliée à la borne (G1) d'application de la tension de commande des structures MIS du type à appauvrissement.

12. Procédé pour la mise en œuvre d'un thyristor selon la revendication 1, caractérisé par le fait qu'on applique à la borne (G1) de la tension de commande des structures MIS du type à appauvrissement une impulsion de tension (P1) d'une première polarité qui provoque la commutation du thyristor de l'état bloqué dans son état passant, et que l'on applique à la borne de tension de commande (G2) des structures MIS du type à enrichissement une impulsion de tension (P2) d'une seconde polarité et qui provoque la commutation du thyristor de son état passant dans son état bloqué.

13. Procédé pour la mise en œuvre d'un thyristor selon la revendication 4, caractérisé par le fait qu'à la borne de tension de commande commune (G) des structures MIS est appliquée une impulsion de tension (P1') d'une première polarité, qui provoque la commutation du thyristor de l'état bloqué dans l'état passant et une seconde impulsion de tension (P2') d'une seconde polarité qui provoque la commutation de l'état passant à l'état bloqué.

# FIG 1

# FIG 2

FIG 3

FIG 4